# EUROPEAN PATENT APPLICATION

(11) **EP 2 639 824 A2**
(43) Date of publication of application: **18.09.2013**
(21) Application number: 12170128.8
(22) Date of filing: 31.05.2012
(51) Int. Cl.: H01L 21/677, H05K 13/04, H01L 21/67

(54) **Robot system and method of manufacturing workpiece**

(30) Priority: 30.11.2011 JP 2011263018
(71) Applicant: Kabushiki Kaisha Yaskawa Denki, Kitakyushu-Shi Fukuoka 806 (JP)
(72) Inventor: Urabe, Katsunori, Kitakyushu-shi, Fukuoka 806-0004 (JP); Shiino, Takashi, Kitakyushu-shi, Fukuoka 806-0004 (JP); Ishibashi, Keigo, Kitakyushu-shi, Fukuoka 806-0004 (JP); Harada,Toshiyuki, Kitakyushu-shi, Fukuoka 806-0004 (JP)
(74) Representative: Grünecker, Kinkeldey, Stockmair & Schwanhäusser

(57) **Abstract**

A robot system (1) according to an aspect of an embodiment includes a supply unit (9) and a robot (10). The supply unit (9) is fixedly provided at a predetermined position to supply a feed material that is used for processing a workpiece. The robot (10) transfers the unprocessed workpiece handed from an operator at a predetermined transfer position to the vicinity of the supply unit (9) to process the workpiece by using the feed material supplied from the supply unit (9) and then transfers the processed workpiece to the transfer position.

## Description

### FIELD

The embodiment discussed herein is directed to a robot system and a method of manufacturing a workpiece.

### BACKGROUND

There has been proposed conventional various robot systems that make robots perform predetermined manufacturing operations on workpieces to achieve the promotion of efficiency of a manufacturing line. For example, a resin sealing apparatus that seals a workpiece, such as a board and a silicon wafer, with resin has been known as disclosed in Japanese Laid-open Patent Publication No. 2003-229444.

The resin sealing apparatus includes a robot and a plurality of units. One of the units includes a liquid discharge apparatus. Moreover, the units are connected by a support rail that is a conveying path for conveying the workpiece.

Herein, the liquid discharge apparatus includes a mobile dispenser that discharges liquid resin to the workpiece. The dispenser discharges liquid resin to a predetermined region of the workpiece while moving over the workpiece conveyed up to a predetermined position of the support rail in three-dimensional directions.

However, the conventional robot systems have further room for improvement from the viewpoint of narrowing of a working space. For example, the resin sealing apparatus requires at least an arranged space of the support rail and a movable space of the dispenser.

An aspect of an embodiment has been achieved in view of the above problem, and an object of the embodiment is to provide a robot system and a method of manufacturing a workpiece that can be used for narrowing a working space.

### SUMMARY

A robot system according to an aspect of an embodiment includes a supply unit and a robot. The supply unit is fixedly provided at a predetermined position to supply a feed material that is used for processing a workpiece. The robot transfers the unprocessed workpiece handed from an operator at a predetermined transfer position to the vicinity of the supply unit to process the workpiece by using the feed material supplied from the supply unit and then transfers the processed workpiece to the transfer position.

According to an aspect of an embodiment, a working space can be narrowed.

### BRIEF DESCRIPTION OF DRAWINGS

A more complete appreciation of the invention and many of the attendant advantages thereof will be readily obtained as the same becomes better understood by reference to the following detailed description when considered in connection with the accompanying drawings, wherein:

FIGs. 1A and 1B are pattern diagrams illustrating the entire configuration of a robot system according to an embodiment;

FIG. 2 is a pattern diagram illustrating the configuration of a robot according to the embodiment;

FIG. 3A is a pattern diagram illustrating the configuration of a robot hand according to the embodiment;

FIG. 3B is a pattern diagram when the robot hand is attached to the robot;

FIGs. 4A, 4B, and 4C are schematic pattern diagrams illustrating operations of the robot system according to the embodiment;

FIGs. 5A, 5B, and 5C are pattern diagrams illustrating a movement of a board relative to a dispenser;

FIG. 6 is a pattern diagram illustrating an example of a vibration isolation process; and

FIGs. 7A, 7B, and 7C are pattern diagrams illustrating a dripping avoidance operation that is performed by the robot.

### DESCRIPTION OF EMBODIMENT

With reference to the accompanying drawings, an embodiment of a robot system and a method of manufacturing a workpiece disclosed in the present application will be described in detail hereinafter. However, the invention is not intended to be restricted by the embodiment described.

Hereinafter, it is assumed that silicon resin that is a liquid material is a "feed material" and a board for an electronics device is a "workpiece". A robot system that attaches silicon resin to a predetermined region of the board and performs a vibration isolation process on electronic components attached to the board will be explained as an example.

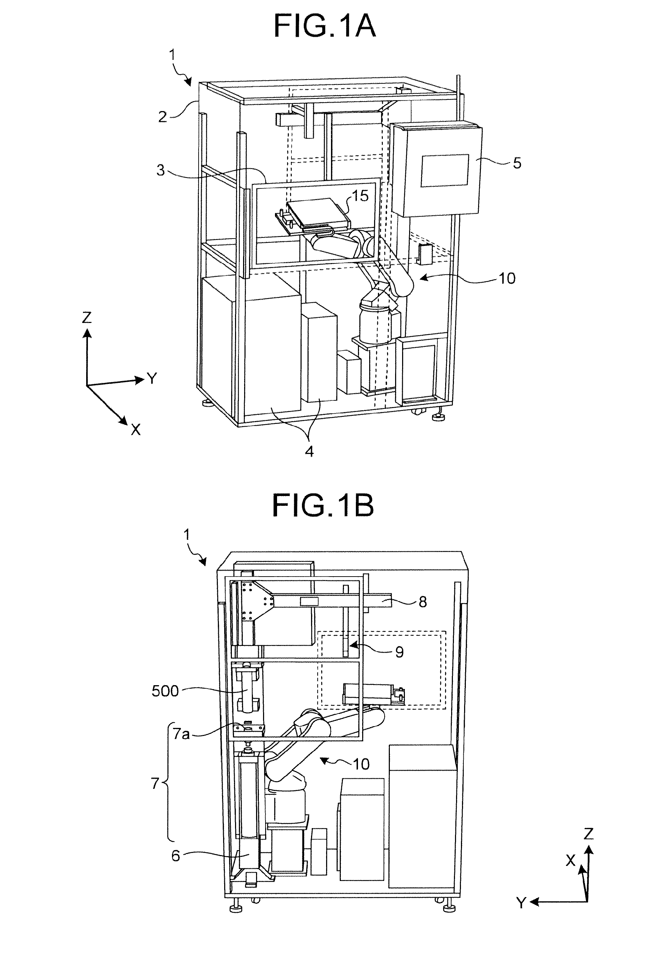

FIGs. 1A and 1B are pattern diagrams illustrating the entire configuration of a robot system 1 according to the embodiment. In order to make an explanation understandable, a three-dimensional rectangular coordinate system that includes Z-axis of which the positive direction is a vertically upward direction is illustrated in FIGs. 1A and 1B. The rectangular coordinate system can be illustrated in other drawings that are used for the following explanations. Hereinafter, it is assumed that the positive direction of X-axis indicates the front of the robot system 1.

As illustrated in FIG. 1A, the robot system 1 includes a partition wall 2 that forms a rectangular solzd-shaped working space. Moreover, a shutter part 3 and a touch panel 5 are provided in the partition wall 2 that corresponds to the front of the working space. The shutter part 3 is an opening part that has an openable and closable shutter. The touch panel 5 is an input device that receives an input instruction of an operator.

As illustrated in FIG. 1A, a control device 4 and a robot 10 are provided inside the partition wall 2 and are connected to communicate with each other.

The control device 4 is a control unit that controls operations of the robot 10. The control device 4 includes various control units, an arithmetic processing unit, a storage device, and the like. Herein, it is illustrated that the control device 4 consists of two cases as an example. However, the number of cases is not limited to this. Moreover, the control device 4 controls the drive of a servo motor 6 to be described below.

As illustrated in FIG. 1A, it is preferable that the control device 4 is provided at a position corresponding to the breast of the robot 10. As a result, the control device 4 can conduce to the narrowing of a working space.

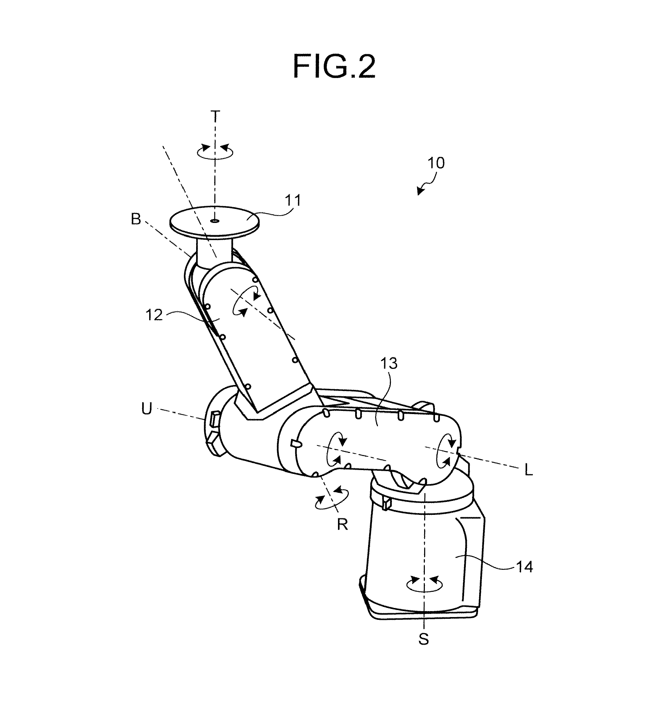

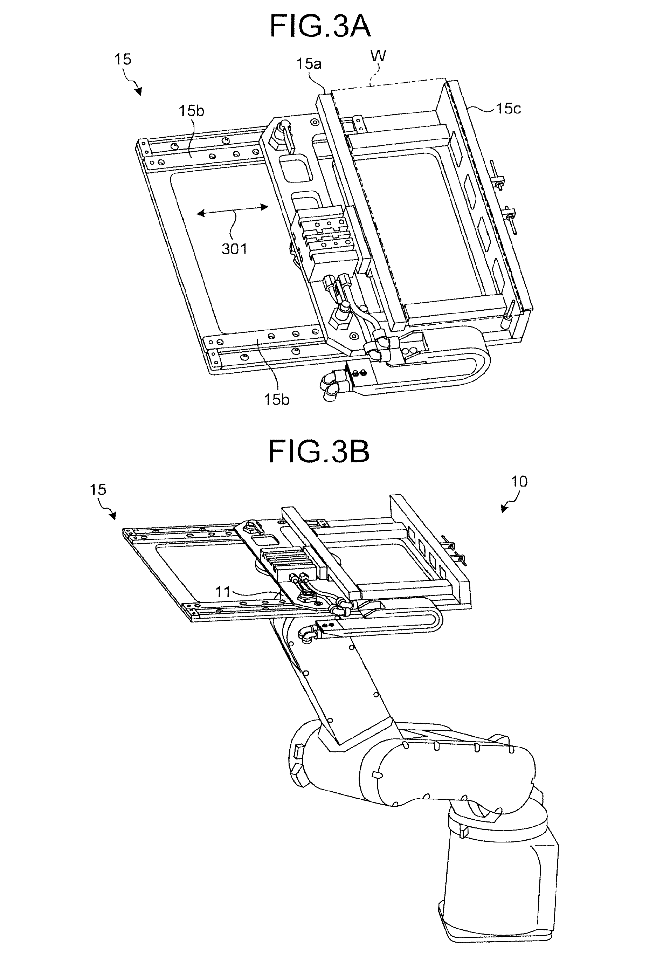

The robot 10 is a manipulator that operates in accordance with an operation instruction provided from the control device 4. The robot 10 includes a robot hand 15 that acts as an end effector. The details of the configuration of the robot 10 are explained below with reference to FIGs. 2, 3A, and 3B.

As illustrated in FIG. 1B, the robot system 1 further includes the servo motor 6, a cylinder part 7, a stand 8, and a dispenser 9 inside the partition wall 2. Moreover, the cylinder part 7 includes a pressurizing unit 7a. Moreover, a silicon cartridge 500 is provided over the pressurizing unit 7a.

The servo motor 6 drives the cylinder part 7 in up and down directions (in other words, Z-axis direction) on the basis of the driving instruction of the control device 4. The cylinder part 7 pressurizes the silicon cartridge 500 from the lower side via the pressurizing unit 7a in accordance with the drive.

The stand 8 is an erected stand that hangs the dispenser 9 that is a "supply unit" that supplies silicon resin. Moreover, a tube (not illustrated) is provided inside the stand 8. The tube sends silicon resin in the silicon cartridge 500 pressurized from the lower side as described above to the dispenser 9 by using the pressurizing force.

The dispenser 9 is hung from the stand 8 and fixes a distal nozzle (not illustrated) at a predetermined position toward the lower side. Then, the silicon resin sent via the tube is discharged on the basis of the discharge instruction of the control device 4.

Next, a configuration example of the robot 10 is explained with reference to FIG. 2. FIG. 2 is a pattern diagram illustrating the configuration of the robot 10 according to the embodiment.

As illustrated in FIG. 2, the robot 10 is a single-bowl multi-axis robot. More specifically, the robot 10 includes a first arm part 11, a second arm part 12, a third arm part 13, and a fourth arm part 14.

A bottom end of the first arm part 11 is supported by the second arm part 12. A bottom end of the second arm part 12 is supported by the third arm part 13 and its leading end supports the first arm part 11.

A bottom end of the third arm part 13 is supported by the fourth arm part 14 and its leading end supports the second arm part 12. A bottom end of the fourth arm part 14 is supported by a base (not illustrated) fixed to a floor of the working space and its leading end supports the third arm part 13.

Each of joints (not illustrated) that are coupling parts of the first arm part 11 to the fourth arm part 14 is provided with an actuator. The robot 10 performs multi-axis operations in accordance with the drives of the actuators.

More specifically, the actuator of the joint that couples the first arm part 11 and the second arm part 12 rotates the first arm part 11 around a B axis. Moreover, the actuator of the joint that couples the second arm part 12 and the third arm part 13 rotates the second arm part 12 around a U axis.

The actuator of the joint that couples the third arm part 13 and the fourth arm part 14 rotates the third arm part 13 around an L axis.

The robot 10 further includes separate actuators that respectively rotate the first arm part 11 around a T axis, the second arm part 12 around an R axis, and the fourth arm part 14 around an S axis.

As illustrated in FIG. 2, a leading end of the first arm part 11 is formed in the shape of a circular plate. The robot hand 15 (see FIG. 1A) is attached to the leading end.

Next, a configuration example of the robot hand 15 is explained with reference to FIGs. 3A and 3B. FIG. 3A is a pattern diagram illustrating the configuration of the robot hand 15 according to the embodiment. FIG. 3B is a pattern diagram when the robot hand 15 is attached to the robot 10.

As illustrated in FIG. 3A, the robot hand 15 includes a slide unit 15a, a guide rail 15b, and a side wall 15c. The slide unit 15a is a moving unit that slides along the guide rail 15b in the direction of a double-headed arrow 301.

As illustrated in FIG. 3A, a board W that is a workpiece is placed between the slide unit 15a and the side wall 15c. Therefore, a moving amount of the slide unit 15a is determined by a width of the board W that is a process target.

As illustrated in FIG. 3B, the robot hand 15 having this configuration is placed on and attached to the leading end of the first arm part 11 and rotates around the T axis (see FIG. 2) along with the first arm part 11.

In other words, it can be said that the robot hand 15 is a rotatable "table" that places thereon the board W.

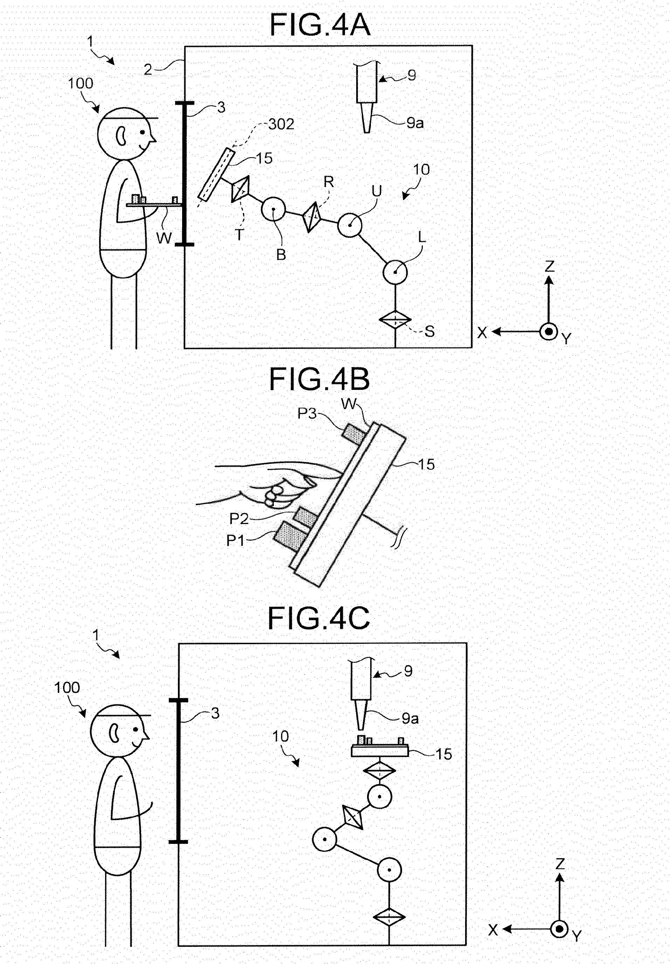

Next, schematic operations of the robot system 1 are explained with reference to FIGs. 4A to 4C. FIGs. 4A, 4B, and 4C are schematic pattern diagrams illustrating operations of the robot system 1 according to the embodiment.

The robot 10 described above is extremely schematically illustrated in FIGs. 4A and 4C. Each joint of the robot 10 is indicated with a circle or a rectangle.

The robot 10 of the robot system 1 according to the embodiment first receives the unprocessed board W from an operator 100 at a predetermined transfer position. More specifically, as illustrated in FIG. 4A, the robot 10 turns the robot hand 15 toward the shutter part 3 provided on the front of the partition wall 2 in accordance with multi-axis operations around the T axis, the B axis, the R axis, the U axis, the L axis, and the S axis. At this time, a shutter of the shutter part 3 is opened together.

At this time, a placement surface of the robot hand 15 on which the board W is placed is inclined to the direction of the operator 100 (see an inclination 302 in the diagram). As a result, the operator 100 can easily place the board W on the placement surface.

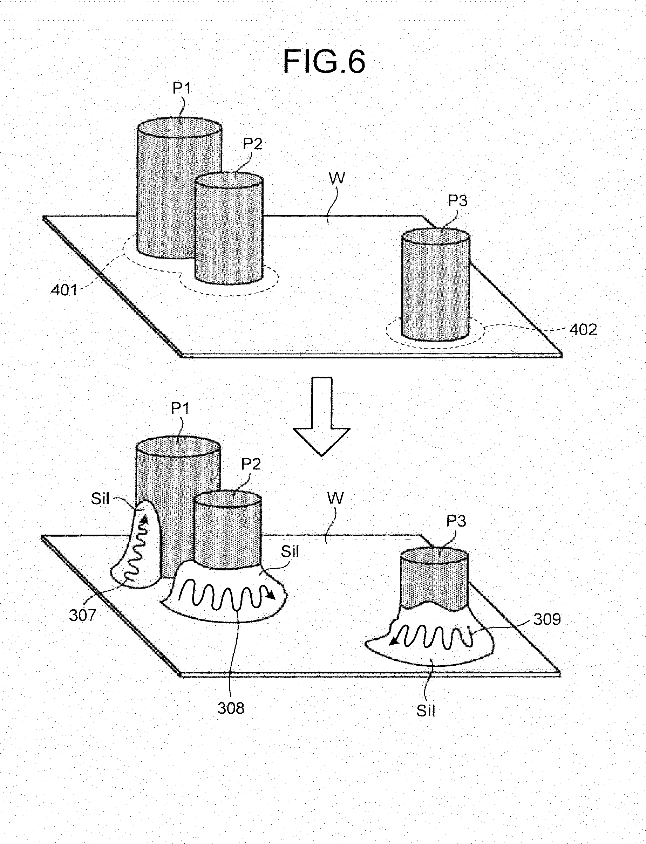

Then, the board W is placed on the robot hand 15 by the hand of the operator 100 as illustrated in FIG. 4B. Moreover, it is assumed that the board W according to the present embodiment is provided with electronic components P1 to P3 such as capacitors attached thereto and predetermined regions around the electronic components P1 to P3 are process targets as illustrated in FIG. 4B. This point is explained below in detail with reference to FIG. 6.

As illustrated in FIG. 4C, the robot 10 transfers the board W to the vicinity of the dispenser 9 in accordance with the multi-axis operations around the axes illustrated in FIG. 4A. More specifically, any of the electronic components P1 to P3 is positioned below a nozzle 9a that is a discharge opening of the dispenser 9. At this time, the shutter of the shutter part 3 is closed together.

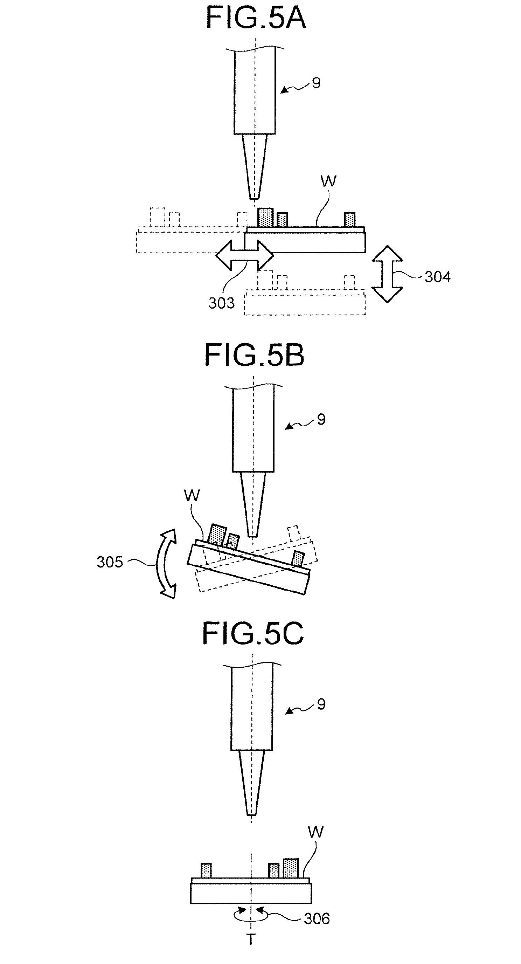

Then, the robot 10 sequentially attaches silicon resin to predetermined regions around the electronic components P1 to P3 while displacing the board W relative to the nozzle 9a (in other words, the dispenser 9) in accordance with the multi-axis operations. The details of this point are explained below with reference to FIG. 5A to FIG. 6.

Then, if the process is performed on all the predetermined regions of the one board W, the robot 10 takes substantially the same posture as that of the case of the transfer time illustrated zn FIG. 4A and transfers the processed board W to the predetermined transfer position (in other words, the vicinity of the shutter part 3).

At this time, the shutter of the shutter part 3 is opened together, and the operator 100 receives the processed board W from the robot 10.

In this way, because the robot system 1 according to the embodiment directly gives and receives the board W between the robot 10 and the operator 100, the robot system 1 does not require a conveying path for the board W such as for example a support rail and a belt conveyor. In other words, a working space can be narrowed.

Because the board W is displaced relative to the fixed dispenser 9, the robot hand 15 that is the leading end of the robot 10 is mainly directed toward the dispenser 9. zn other words, because the movable range of the robot hand 15 can be comparatively reduced, the robot system can conduce to the narrowing of the working space.

Next, a movement of the board W relative to the fixed dispenser 9 is explained with reference to FIGs. 5A to 5C. FIGs. 5A, 5B, and 5C are pattern diagrams illustrating the movement of the board W relative to the dispenser 9.

As illustrated in FIG. 5A, the robot 10 displaces the board W with respect to the dispenser 9, for example, in a horizontal direction (see a double-headed arrow 303 of FIG. 5A) in accordance with the multi-axis operations around the axes (see FIG. 4A). Similarly, the robot 10 displaces the board W in a vertical direction (see a double-headed arrow 304 of FIG. 5A).

As illustrated in FIG. 5B, the robot 10 displaces the board W with respect to the dispenser 9, for example, to have an inclination (see a double-headed arrow 305 of FIG. 5B).

As illustrated in FIG. 5C, the robot 10 rotates the board W with respect to the dispenser 9, for example, around the T axis (see a double-headed arrow 306 of FIG. 5C).

The robot 10 can appropriately attach silicon resin to detailed places by combining the movements relative to the dispenser 9 illustrated in FIGs. 5A to 5C, for example, even if the electronic components are densely attached.

Because the robot 10 performs the multi-axis operations in the state where the distal robot hand 15 is always directed to the fixed dispenser 9, the embodiment has a merit that mutual interference between the arms of the robot 10 is not easily caused.

Furthermore, because the robot 10 receives silicon resin discharged from the fixed dispenser 9 and attaches the silicon resin to the predetermined regions of the board W, the embodiment can have a merit that dripping is not easily received, for example, compared to the case where the dispenser 9 is a mobile type.

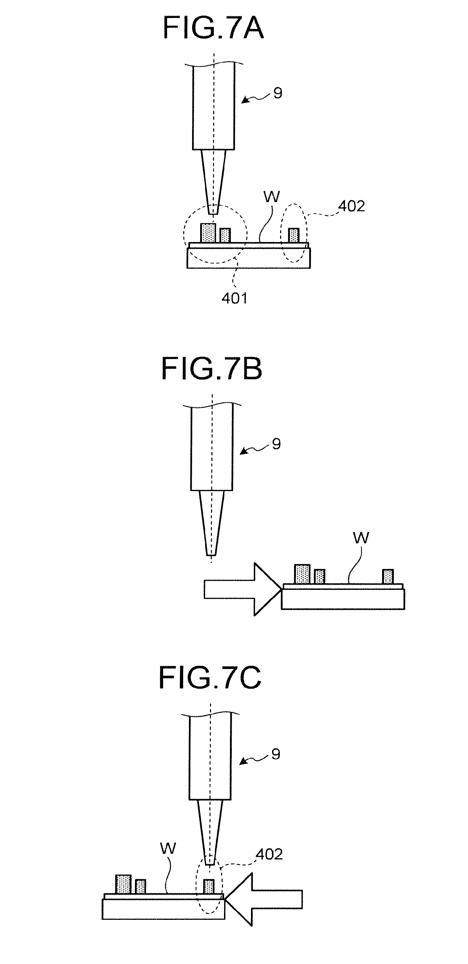

Moreover, the robot 10 may perform an operation for avoiding the dripping. This point is explained below with reference to FIGs. 7A to 7C.

Moreover, when the board W is displaced relative to the fixed dispenser 9, the dispenser 9 is relatively moved if the board W is used as a reference. Hereinafter, in consideration of this point, an expression that the dispenser 9 is relatively moved may be employed when an explanation is performed by using the board W as a reference.

Next, a vibration isolation process performed on the board W by the robot system 1 according to the embodiment is specifically explained with reference to FIG. 6. FIG. 6 is a pattern diagram illustrating an example of a vibration isolation process. Herein, an upper portion of FIG. 6 illustrates a pattern diagram of the unprocessed board W and a lower portion of FIG. 6 illustrates a pattern diagram of the processed board W.

As illustrated in the upper portion of FIG. 6, it is assumed that the board W is provided with the electronic components P1 to P3 attached thereto. Herein, as illustrated in the upper portion of FIG. 6, the electronic components are densely attached (see the electronic components P1 and P2) and are sparsely attached (see the electronic component P3). Moreover, it is general that the electronic components have various sizes.

Herein, the robot system 1 treats regions around the electronic components P1 to P3 as predetermined regions 401 and 402 on which the vibration isolation process is predetermined. In other words, the predetermined region 401 and the predetermined region 402 are regions that include regions on which the board W and the electronic components P1 to P3 are connected.

Information on the predetermined region 401 and the predetermined region 402 is associated with the type of the board W, the type of the electronic components P1 to P3, and the like. For example, the information is previously stored in a storage device included in the control device 4.

As illustrated in the lower portion of FIG. 6, the robot system 1 attaches silicon resin Sil to the predetermined region 401 and the predetermined region 402. Moreover, the form of the adhesion can be determined in accordance with the height, the attachment position, and the density of the electronic components P1 to P3, the relative travel distance of the dispenser 9, and the like.

For example, the silicon resin Sil can be attached to the electronic component P1, which has a predetermined height compared to the electronic component P2 and the electronic component P3, in the height direction (see an arrow 307 of FIG. 6) of the electronic component P1 from the surface of the board W.

Moreover, the silicon resin Sil can be attached to the electronic component P2 adjacent to the electronic component P1, for example, in the direction of an arrow 308 taken along the surface of the board W.

Moreover, the silicon resin Sil may be attached to the electronic component P3 in the direction of an arrow 309 that is an inverse direction against the electronic component P2.

Moreover, in the lower portion of FIG. 6, the arrows 307, 308, and 309 indicate waved arrows. This indicates that the robot 10 attaches the silicon resin Sil to the board W while the robot 10 vibrates (so-called, weaving) the board W with a predetermined amplitude.

In other words, because the silicon resin Sil is attached in a wavy shape through the weaving and thus can be sufficiently attached in a stacking manner, the vibration isolation process by which the electronic components P1 to P3 are surely fixed to the board W can be performed.

Next, a dripping avoidance operation performed by the robot 10 is explained with reference to FIGs. 7A to 7C. FIGs. 7A, 7B, and 7C are pattern diagrams illustrating a dripping avoidance operation that is performed by the robot 10.

For convenience of explanation, the predetermined region 401 and the predetermined region 402 illustrated in FIG. 6 are largely illustrated daringly exaggeratingly in FIGs. 7A and 7C.

As illustrated in FIG. 7A, the predetermined region 401 and the predetermined region 402 of the board W are arranged away from each other by a predetermined amount. In other words, this indicates that a relative travel distance of the dispenser 9 is comparatively large when being viewed from the board W.

In this case, a region other than the predetermined region 401 and the predetermined region 402 of the board W may be subjected to dripping from the dispenser 9.

Therefore, when the robot 10 relatively moves the dispenser 9 from the predetermined region 401 to the predetermined region 402, the robot 10 once evacuates the whole of the board W from the area (in other words, the lower side of the dispenser 9) to which the silicon resin is supplied, as illustrated in FIG. 7B.

Then, the robot 10 waits for a predetermined time for which dripping can be avoided and then again positions the predetermined region 402 of the board W under the dispenser 9 as illustrated in FIG. 7C. As a result, dripping can be surely avoided and thus a vibration isolation process having a high quality can be performed.

As described above, a robot system according to the embodiment includes a supply unit and a robot. The supply unit is fixedly provided at a predetermined position to supply a feed material that is used for processing a workpiece. The robot transfers the unprocessed workpiece handed from an operator at a predetermined transfer position to the vicinity of the supply unit to process the workpiece by using the feed material supplied from the supply unit, and then transfers the processed workpiece to the transfer position.

Therefore, according to the robot system according to the embodiment, a working space can be narrowed.

Meanwhile, it has been explained in the embodiment that the workpiece is a board for an electronics device and silicon resin that is the feed material is attached to a predetermined region of the board. However, the workpiece, the feed material, the aspect of the process, and the like are not intended to limit the present invention. For example, assuming that a wafer is used as the workpiece and an adhesive is used as the feed material, a process for applying the adhesive to the wafer may be performed.

It has been explained in the embodiment that a liquid material called silicon resin is a feed material. However, the present embodiment is not limited to this. For example, the present embodiment may be applied to the case when laser processing is performed by using a laser beam as a feed material or when arc welding is performed by using a welding rod as a feed material.

Moreover, it has been explained in the embodiment that the robot is a single-arm robot. However, the present embodiment is not limited to this. For example, a two-arm robot or a multi-arm robot that includes three or more arms may be applied to a process that is performed on a workpiece. Moreover, it has been explained in the embodiment that the robot is a six-axis robot. However, the number of its not limited this.

## Claims

1. A robot system (1) comprising:
a supply unit (9) that is fixedly provided at a predetermined position to supply a feed material that is used for processing a workpiece; and
a robot (10) that transfers the unprocessed workpiece handed from an operator at a predetermined transfer position to a vicinity of the supply unit (9) to process the workpiece by using the feed material supplied from the supply unit (9) and then transfers the processed workpiece to the transfer position.

2. The robot system (1) according to claim 1, wherein
the robot (10) includes a table (15) that places thereon the workpiece, and
the table (15) is inclined toward the operator when transferring the workpiece at the transfer position.

3. The robot system (1) according to claim 1 or 2, wherein
the feed material is a liquid material, and
the robot (10) attaches the liquid material to a predetermined region of the workpiece while displacing the workpiece relative to the supply unit (9).

4. The robot system (1) according to claim 3, wherein the robot (10) vibrates the workpiece with a predetermined amplitude in such a manner that the liquid material is attached to the predetermined region in a wavy shape.

5. The robot system (1) according to claim 3 or 4, wherein
the workpiece has a plurality of predetermined regions, and
the robot (10) once evacuates the workpiece from an area to which the liquid material is supplied when the supply unit (9) is relatively moved from the one predetermined region to the other predetermined region.

6. The robot system (1) according to claim 3, 4, or 5, wherein
the liquid material is silicon resin (Sil),
the workpiece is a board (W) for an electronics device, and
the predetermined region includes regions on which the board (W) and electronic components (P1, P2, P3) attached to the board (W) are connected.

7. A method of manufacturing a workpiece, the method comprzsing:
supplying a feed material from a fixed predetermined position; and
making a robot (10) transfer an unprocessed workpiece handed from an operator at a predetermined transfer position to a vicinity of the predetermined position to process the workpiece by using the feed material supplied from the predetermined position and then transfer the processed workpiece to the transfer position.
